# EUROPEAN PATENT SPECIFICATION

(11) **EP 2 045 834 B1**
(45) Date of publication and mention of the grant of the patent: **02.02.2011**
(21) Application number: 08252981.9
(22) Date of filing: 09.09.2008
(51) Int. Cl.: H01L 21/00, H01L 21/687, H01L 21/683, H02N 13/00

(54) **Heating apparatus**
Erhitzungsvorrichtung
Appareil de chauffage

(30) Priority: 10.09.2007 JP 2007234485
(43) Date of publication of application: 08.04.2009
(73) Proprietor: NGK Insulators, Ltd., Nagoya-City, Aichi Pref. 467-8530 (JP)
(72) Inventor: Morioka, Ikuhisa, Nagoya City, Aichi Pref., 467-8530 (JP); Tsuruta, Hideyoshi, Nagoya City, Aichi Pref., 467-8530 (JP); Aihara, Yasufumi, Nagoya City, Aichi Pref., 467-8530 (JP)
(74) Representative: Paget, Hugh Charles Edward

(56) References cited:
- JP-A- 9 249 465
- US-A1- 2005 215 073
- US-B1- 6 538 872

## Description

### BACKGROUND OF THE INVENTION

### 1. Field of the invention

The present invention relates to a heating apparatus, which is used for heating a semiconductor wafer and the like.

### 2. Description of the related art

In a process of manufacturing a semiconductor device, a heating process is performed to form an oxide film and the like on a wafer by using a semiconductor manufacturing device. A heating apparatus provided with a disk-shaped ceramic base is an example of the heating apparatus used for performing the wafer-heating process. The disk-shaped ceramic base has a heating surface on which a wafer is set, and has a resistance heating body embedded therein. The resistance heating body of the heating apparatus, which is embedded inside the ceramic base, heats the heating surface with an electric power supplied to the resistance heating body.

Such a heating apparatus is required to heat the wafer so as to maintain the wafer constantly at a predetermined heating temperature. The heating apparatus is also required to heat uniformly within the surface of the wafer. Thus, there has been known heating apparatuses such as one in which a planar wiring of a resistance heating body is modified, and one in which a bulk heat sink is attached to a back surface of a disk-shaped ceramic base, as a temperature adjusting member. Such bulk heat sink can rapidly release the heat from the ceramic base. Thus, a local temperature increase on the heating surface can be suppressed, thereby contributing to heat the wafer uniformly over the entire heating surface.

Further, a heating apparatus is known in which the bulk heat sink and the ceramic base are joined with an adhesion layer composed of silicone resin. However, silicone resin has a low heat resistance, and thus limits the temperature at which the heating apparatus can be used. Furthermore, due to a poor thermal conductivity of silicone resin, there is a limitation in uniformly heating and maintaining the wafer at the heated temperature.

In this regard, a heating apparatus is known in which the bulk heat sink and the ceramic base are joined by a junction layer formed by a thermal compression bonding of aluminum alloy (see Japanese Patent Application Publication No. H 9-249465).

However, even in such heating apparatus, sufficient uniformity of the heating temperature in the heating surface of the ceramic base cannot always be obtained. The heating uniformity (thermal uniformity) is deteriorated particularly when the heat input to the resistance heating body is increased, or when the ceramic base is composed of a material having low thermal conductivity. Accordingly, uniformity is also deteriorated in the surface temperature of the wafer heated by such heating apparatus. The deterioration in the uniformity of the temperature of the wafer surface lowers the uniformity in a coating and an etching performed on the surface of the wafer. As a result, the production yield of the semiconductor device is reduced.

US-B-6538872 illustrates an electrostatic chuck having an electrostatic member providing a surface on which a wafer is supported and joined at its opposite face to a base by a metal bond layer. The base contains a heater. The base is in turn connected by a metal bond layer to a support. In one construction (Fig. 7c) the support has a cavity within it which has a gas inlet and gas outlet for supplying and removing a gas. By varying the pressure of the gas in the cavity, the amount of heat conducted from the chuck through the support can be varied.

US 2005/0215073A similarly shows a wafer supporting member. The wafer support body is joined by adhesive to an insulating resin body containing a heater. The insulating resin body is connected by two adhesive layers to a conductive base part which contains a passage for circulation of cooling medium.

### SUMMARY OF THE INVENTION

The invention provides a heating apparatus as set out in claim 1.

### BRIEF DESCRIPTION OF THE DRAWINGS

Fig. 1 is a cross-sectional view showing an embodiment according to a heating apparatus of the present invention.
Fig. 2 is an explanatory drawing showing an example of a heating system including the heating apparatus of the embodiment of the present invention.

### DESCRIPTION OF THE PREFERRED EMBODIMENT

An embodiment of a heating apparatus of the present invention will be described below with reference to the accompanying drawings.

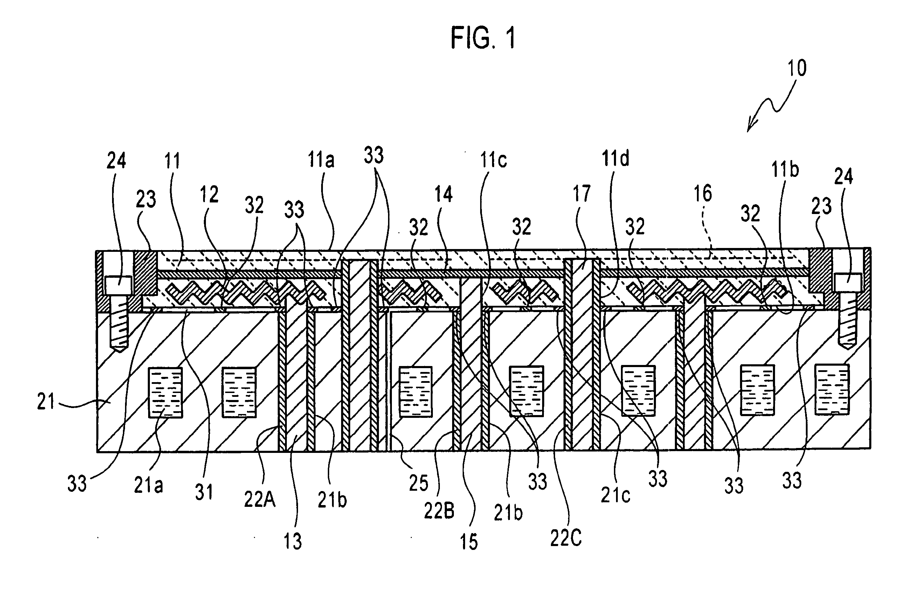

Fig. 1 is a cross-sectional view showing an embodiment according to the heating apparatus of the present invention. In the drawings described below, each component is depicted at a dimensional ratio different from that of the actual heating apparatus to facilitate understanding of each component of the heating apparatus. Accordingly, the dimensional ratio of the heating apparatus according to the present invention is not limited to that shown in the drawings.

A heating apparatus 10 of the present embodiment shown in Fig: 1 has a disk-shaped ceramic base 11. The ceramic base 11 is composed of, for example, alumina (Al₂O₃)-based ceramic or aluminum nitride (AlN)-based ceramic.

On one of a planar surface of the disk-shaped ceramic base 11, such as a wafer (not shown) used as a semiconductor substrate, which is an object to be heated, is set. Here, the planar surface serves as a heating surface 11a for heating the wafer. In the ceramic base 11, a resistance heating body 12 is embedded proximal to a back surface 11b opposite to the heating surface 11a.

A heater terminal 13 connected to the resistance heating body 12 is inserted from the back surface 11b of the ceramic base. The resistance heating body 12 generates heat when an electric power is supplied thereto from an external power source (not shown) connected to the heater terminal 13. The generated heat is then transferred through the ceramic base 11 from the resistance heating body 12 to the heating surface 11a of the ceramic base 11. Thus, the wafer set on the heating surface 11a can sssbe heated.

A temperature adjusting member 21 is fixedly fastened to the ceramic base 11 while facing the back surface 11b of the ceramic base 11. In the example shown in the figure, a ring-shaped fixture 23 is provided proximal to the circumferential portion of the ceramic base 11. The fixture 23 is formed in a shape having a cutout that engages with a flange in the circumferential portion of the ceramic base 11. Here, the cutout indicates the inner circumference of the fixture 23. The fixture 23 also has a bolt hole penetrating in the thickness direction thereof. A bolt 24 is inserted through the bolt hole. The bolt 24 is screw-connected to a screw hole formed in the temperature adjusting member 21 to fixedly fasten the ceramic base 11 to the temperature adjusting member 21. As described below in detail, an air gap 31 is provided between the ceramic base 11 and the temperature adjusting member 21.

The temperature adjusting member 21 is composed of a metallic material such as a bulk aluminum having a good thermal conductivity, which can transfer the heat of the ceramic base 11 so as to keep the temperature of the heated ceramic base 11 constant. In order to improve a heat releasing effect of the temperature adjusting member 21A, a fluid flow hole 21a through which a cooling medium can pass is formed in the temperature adjusting member 21. Further, in the temperature adjusting member 21, a terminal hole 21b to which the heater terminal 13 can be inserted is formed. In addition, a tubular-shaped insulation member 22A is provided in contact with the inner wall of the terminal hole 21b, so as to insulate the heater terminal 13 inserted on the inner circumferential side of the insulation member 22A from the temperature adjusting member 21 composed of a metallic material.

In the heating apparatus 10 of the present embodiment, a heat conductive member 14 is disposed between the heating surface 11a of the ceramic base 11 and the resistance heating body 12 embedded in the ceramic base 11. In the present embodiment shown in the figure, the heat conductive member has a thin plate shape having approximately the same planar shape and diameter as those of the heating surface 11a, and is set almost parallel to the heating surface 11a. The heat conductive member 14 has a higher thermal conductivity than the ceramic base 11.

The heating apparatus 10 provided with the heat conductive member 14 as described above can achieve the following effects. When the resistance heating body 12 is supplied with an electric power and thereby generates heat, a part of the generated heat is transferred towards the heating surface 11a of the ceramic base 11. The heat which reaches the heat conductive member 14 in the process of transfer to the heating surface 11a is not only transferred from the heat conductive member 14 to the heating surface 11a, but also diffusively transferred in the planar directions inside the heat conductive member 14. This diffusive transfer of the heat makes it possible to even out the heat amount directed to the heating surface 11a in the planar directions of the heat conductive member 14. As a result, the heat directed to the heating surface 11a is also evened out in the planar directions of the heating surface 11a. Thus, the uniformity of the temperature (thermal uniformity) on the heating surface 11a is improved.

The above-described effect is particularly advantageous when the ceramic base 11 is composed of a ceramic containing alumina as a main component. The thermal conductivity of alumina is as low as approximately 30W/m ·K. Accordingly, when the heat conductive member 14 is not provided, only a small amount of the heat generated from the resistance heating body 12 is diffusively transferred in the planar directions inside the ceramic base 11. Consequently, the thermal uniformity may not be sufficient. On the contrary, the heating apparatus of the present invention can dramatically improve the thermal uniformity by containing the heat conductive member 14, even when the ceramic base 11 is composed of a ceramic containing alumina as a main component.

The thermal uniformity caused by including the heat conductive member 14 is improved since the heat conductive member is disposed proximal to the heating surface 11a, and between the heating surface 11a of the ceramic base 11 and the resistance heating body 12. This improvement effectively contributes to the improvement in the overall thermal uniformity. Accordingly, the thermal uniformity of the heating apparatus 10 according to this embodiment can be far superior to the heating apparatus of the prior art, which simply includes the temperature adjusting member 21 on the back surface 11b of the ceramic base 11. A semiconductor wafer to be heated by the heating apparatus 10 has a large influence on the production yield of the semiconductor device. Even a small variation in the temperature on the surface of the wafer largely influences the production yield of the semiconductor device. Accordingly, this improvement in the thermal uniformity leads to a dramatic improvement in the production yield of the semiconductor device.

A material having a higher thermal conductivity than the ceramic base 11 is suitable for the heat conductive member 14. The higher the thermal conductivity is, the more preferable it is. For example, when the ceramic base 11 is composed of alumina (thermal conductivity: about 30W/m ·k), the heat conductive member 14 is preferably composed of aluminum or aluminum alloy (thermal conductivity: about 230W/m ·k). The heat conductive member 14 is not limited to aluminum or aluminum alloy but may otherwise be composed of indium, indium alloy, or another metallic material having a good thermal conductivity. Furthermore, not only metallic material but also aluminum nitride (thermal conductivity: about 150W/m ·k) which is a ceramic having a high thermal conductivity may be used.

The heat conductive member 14 needs to have a certain thickness to sufficiently diffuse the heat in its planar directions. For example, a thickness of about 0.5 mm to 5.0 mm is preferable. If the thickness of the heat conductive member 14 is smaller than about 0.5 mm, a diffusion of the heat in its planar directions is insufficient and the effect caused by containing the heat conductive member 14 is reduced. If the thickness of the heat conductive member 14 is larger than about 5.0 mm, the effect of containing the heat conductive member 14 is saturated. The thickness of about 0.5 mm to 5.0 mm of the heat conductive member 14 is significantly different from a thickness of a metal electrode sometimes embedded between a heating surface and a resistance heating body in a conventional heating apparatus. Examples of the metal electrode include: an electrode for generating electrostatic force on the heating surface 11a, and a high frequency electrode for generating plasma proximal to the heating surface 11a. The thickness of the electrode of a conventional heating apparatus hardly allows for improvement in the thermal uniformity desired in the present invention.

The ceramic base 11 is not limited to the ceramic containing alumina as a main component and may be one composed of ceramic containing yttrium oxide as a main component. In this case, the heat conductive member may be composed of a metallic material having a higher thermal conductivity than yttrium oxide, such as aluminum, aluminum alloy, indium, and indium alloy. The ceramic base 11 may also be composed of ceramic containing aluminum nitride as a main component. A ceramic base composed of aluminum nitride has a volume resistivity suitable for generating an electrostatic force using Johnson-Rahbeck force. In this case, the heat conductive member may be composed of a metallic material having a higher thermal conductivity than aluminum nitride, such as aluminum and aluminum alloy.

The heat conductive member 14 has approximately the same plane shape and size as those of the heating surface 11a of the ceramic base 11. This gives an advantage in that the uniformity of the heating temperature (thermal uniformity) is improved on the heating surface 11a. However, the plane shape and size of the heat conductive member 14 are not limited to the above. Any material can be served as the heat conductive member 14, as long as the heat conductive member 14 has a plane shape and size that allow the thermal uniformity to be improved and is disposed between the heating surface 11a and the resistance heating body 12 inside the ceramic base 11.

The resistance heating body 12 is composed of a metallic material having a high melting point, such as Nb (niobium), Pt (platinum), W (tungsten), and Mo(molybdenum), or the carbide (exclusive of platinum) thereof. Such resistance heating body 12 may be formed in a planar shape by applying raw material paste containing the foregoing metallic material, or may be a coil resistance heating body.

When considering the preferable size and shape of the heat conductive member 14, it is preferable that the ceramic base 11 is divided into two portions including an upper portion on which a substrate (wafer) is set, and a lower portion which faces the temperature adjusting member. Further, it is preferable that the heat conductive member 14 is disposed between the upper portion and the lower portion so that the ceramic base 11 has a three-layer structure. The heating apparatus of the present embodiment shown in Fig. 1 has this preferable three-layer structure. The heating apparatus according to the present invention, however, is not limited to the three-layer structure. The heat conductive member 14 may be embedded in the ceramic base 11, for example.

A structure can be formed in a manner that the upper portion and lower portion of the ceramic base 11 divided into two portions in the vertical direction are joined by thermal compression bonding (TCB) with the heat conductive member 14 interposed therebetween. In the three-layers structure, the heat conductive member is formed by the thermal compression bonding. Thereby, the upper and lower portions of the ceramic base 11 can be fixedly fastened to each other without including an air gap over the joint surface. As a result, the heat conductive member 14 has an excellent heat conducting effect without any adverse effect on the entire strength of the ceramic base 11 and.

When the ceramic base 11 is divided into the upper portion and the lower portions, a difference of thermal expansion coefficients between the upper and lower portions of the ceramic base 11 is preferably 0.2 × 10⁻⁶ or less. The difference between thermal expansion coefficients of more than 0.2 × 10⁻⁶ causes a warpage of the ceramic base 11, which may require a work for flattening the warpage.

The upper portion of the ceramic base 11 preferably has a volume resistivity of 1 × 10⁸ to 1 × 10¹²Ω ·cm, or 1 × 10¹⁵Ω ·cm or more in the use temperature. The volume resistivity of 1 × 10⁸ to 1 × 10¹²Ω ·cm is preferable for generating the electrostatic force using Johnson-Rahbeck force on the heating surface 11a. The volume resistivity of 1 × 10¹⁵Ω ·cm or more provides a high insulation and thereby preferable for generating the electrostatic force using Coulomb force. The volume resistivity ranging from more than 1 × 10¹²Ω ·cm to less than 1 × 10¹⁵Ω ·cm cannot generate the electrostatic force satisfactorily and reduces a wafer removal response after adsorbing and retaining a wafer. The volume resistivity less than 1 × 10⁸Ω ·cm increases a leak current and has an adverse effect on the wafer, which may result in a reduction in the yield.

The lower portion of the ceramic base preferably has a volume resistivity of 1 × 10⁸Ω ·cm or more in the use temperature. The volume resistivity of less than 1 × 10⁸Ω ·cm causes a leak current in the lower portion, which may result in an insulation failure.

The heating apparatus 10 of the present embodiment is provided with the heat conductive member 14 disposed in parallel to and proximal to the heating surface 11a of the ceramic base 11. Accordingly, the heat conductive member 14 can be used as a high frequency electrode. More specifically, the heating apparatus having the ceramic base 11 includes a heating apparatus embedding a disk-shaped high frequency electrode capable of applying a high frequency proximal to the heating surface, thereby able to generate plasma in a space proximal to an object to be heated and set on the heating surface. Such high frequency electrode is generally composed of a conductive member to which a high frequency electric power can be supplied. Accordingly, in the heating apparatus 10 of the present embodiment, the heat conductive member 14 can be used as the high frequency electrode when the heat conductive member 14 is composed of the conductive member such as a metallic material. In the heating apparatus 10 of the present embodiment shown in Fig. 1, the heat conductive member 14 also serves as the high frequency electrode. Therefore, a hole 11c is formed on the back surface 11b of the ceramic base 11 so as to reach the heat conductive member 14, and to enable a high frequency electrode terminal 15 to be inserted and be connected to the heat conductive member 14. In addition, in the temperature adjusting member 21, a terminal hole 21b is formed on the extended line of the hole 11c. A tuber-shaped insulation member 22B is provided in contact with the inner wall of the terminal hole 21b, and to insulate the high frequency electrode terminal 15 inserted on the inner circumferential side of the insulation member 22B, from the temperature adjusting member 21 composed of a metallic material. The high frequency electrode terminal 15 is connected to the heat conductive member 14, through the terminal hole 21b of the temperature adjusting member 21 and the hole 11c of the ceramic base 11. The heat conductive member 14 becomes usable as the high frequency electrode by supplying a high frequency electric power from outside, through the high frequency electrode terminal 15. As a result, the heating apparatus 10 does not need to have a separate high frequency electrode. Note that if the heat conductive member is composed of a metallic material, the heat conductive member is in some cases corroded by the generated high frequency plasma. To prevent the corrosion of the heat conductive member, it is only necessary to protect a side surface of the heat conductive member by means of an anti-corrosion material. For example, the heat conductive member can be protected by providing a film or ring made of anti-corrosive ceramic and anti-corrosive resin. A specific method of forming an anti-corrosive material includes, for example, the use of a sprayed film made of alumina ceramic, yttrium aluminum garnet, yttria ceramic and the like, a heat-shrinkable ring made of fluorine resin, or the like.

The heating apparatus 10 of the present embodiment may be provided with an electrostatic chuck to retain a wafer set on the heating surface 11a of the ceramic base 11 by using the electrostatic force. Comprising the electrostatic chuck allows the heating apparatus to adsorb and retain a wafer during heating of the wafer. For this reason, the heating apparatus 10 of the present embodiment is provided with an electrostatic electrode 16 embedded in a position proximal to the heating surface 11a in the ceramic base 11. A hole 11d is formed on the back surface 11b of the ceramic base 11 so as to reach the electrostatic electrode 16, thereby enabling an electrostatic electrode terminal 17 to be inserted and be connected to the electrostatic electrode 16. In addition, in the temperature adjusting member 21, a terminal hole 21c is formed on the extended line of the hole 11d. A tubular-shaped insulation member 22C is provided in contact with the inner wall of the terminal hole 21c. The insulation member 22C is provided to insulate the electrostatic electrode terminal 17, which is inserted on the inner circumferential side of the insulation member 22C, from the temperature adjusting member 21, whish is composed of a metallic material. Here, an insulation material such as a resin adhesive agent may be applied in a clearance between the insulation member and each of the holes 21a to 21c, in order to eliminate the clearance while increasing the bonding strength and the dielectric breakdown strength. When a voltage is applied from outside to the electrostatic electrode 16 through the electrostatic electrode terminal 17, the region between the electrostatic electrode 16 and the heating surface 11a is polarized to become a dielectric layer. Thus, the electrostatic force is generated on the heating surface 11a. The electrostatic force can be used to adsorb and retain the wafer. When at least the region between the electrostatic electrode 16 and the heating surface 11a of the ceramic base 11 is composed of alumina, a powerful electrostatic force by use of Coulomb force can be generated, since alumina has appropriate electric resistivity. An electrostatic force by Coulomb force does not require a slight amount of current on the heating surface 11a as in the case of the electrostatic force by Johnson-Rahbeck force.

The electrostatic electrode 16 preferably contains tungsten carbide (WC) and 10% or more of alumina. When the electrostatic electrode 16 contains tungsten carbide as a main component, an extremely small amount of the component of the electrostatic electrode 16 is diffused in alumina. As a result, the volume resistivity of alumina proximal to the electrostatic electrode 16 can be increased. This increase leads to an improvement in the insulation property when a high voltage is applied, and to an improvement in the removal property of the adsorbed substrate in association with high resistance of the dielectric layer. Additionally, when the electrostatic electrode 16 contains 10% or more of alumina, the contact property of the electrostatic electrode 16 is improved. The upper limit of the amount of alumina contained in the electrostatic electrode 16 is preferably about 50% by weight or less from the point of view of reducing the electric resistance of the electrostatic electrode 16.

The electrostatic electrode 16 can be printed in the form of a planar shape such as a mesh, a comb, and a spiral pattern by use of a print paste which contains a powder mixture of a predetermined amount of alumina and tungsten carbide, for example. The heating apparatus 10 of the present embodiment shown in Fig. 1 is an example of a bipolar type of the electrostatic electrode 16. However, the electrostatic electrode 16 is not limited to the bipolar type, and may be of a monopolar type, or of a multipolar type.

When the ceramic base 11 is divided into the upper and lower portions with the heat conductive member 14 interposed therebetween to form a three-layer structure, and when the heating apparatus includes an electrostatic chuck, it is preferable that the electrostatic electrode 16 is included in the upper portion of the ceramic base 11 and the resistance heating body 12 is included in the lower portion of the ceramic base 11. Since the electrostatic electrode 16 is embedded in a position proximal to the heating surface 11a of the ceramic base 11, the electrostatic electrode 16 is provided in the upper portion of the ceramic base. On the other hand, the heat conductive member 14 is provided in the lower portion of the ceramic base 11, since the heat conductive member 14 is provided in order to diffuse and transfer the heat directed from the resistance heating body 12 to the heating surface 11a of the ceramic base 11, in the planar direction of the heat conductive member 14.

An exemplar method of manufacturing the heating apparatus 10 of the present embodiment includes a process of separately manufacturing the upper and lower portions of the ceramic base 11 divided in the vertical direction thereof. Thereafter, the upper and lower portions are joined by the thermal compression bonding with the heat conductive member 14 interposed therebetween.

The thermal compression bonding can be carried out by using aluminum as the heat conductive member 14, for example, stacking the previously manufactured upper and lower portions of the ceramic base 11 with the aluminum heat conductive member 14 interposed therebetween. Then, the portions of the ceramic base 11 and the heat conductive member 14 are heated at a predetermined temperature while being compressed in the thickness direction. In particular, it is recommended to set the predetermined temperature to a temperature 5°C to 15°C lower than the melting point of aluminum, the compressing pressure to ranging from 10kg/cm² or more to 100 kg/cm² or less, and the atmosphere to vacuum of 1kPa or less. This method allows for a uniform junction at a low temperature, and thus the members can be joined without melting the aluminum. Consequently, the heat conductive member 14 is not deformed, the ceramic base is absolutely not deformed at this temperature, and a ceramic base of a highly precise dimension can be obtained. The aluminum can be previously stamped out in an arbitrary shape from a sheet, and is not melted during thermal compression bonding. Accordingly, the aluminum can be joined without interfering with through holes provided in the ceramic base.

Furthermore, in manufacturing the ceramic base 11, the upper and lower portions of the ceramic base 11 used in the thermal compression bonding can be manufactured separately. This allows the upper and lower portions of the ceramic base 11 to be manufactured in different types of ceramic. For example, the upper portion can be manufactured by using a ceramic containing yttria as a main component, and the lower portion can be manufactured by using a ceramic containing alumina as a main component.

As shown in Fig. 1, the heating apparatus 10 of the present embodiment is provided with an air gap 31 provided between the ceramic base 11 in which the foregoing heat conductive member 14 is disposed, and the temperature adjusting member 21. A spacer 32 is arranged in the air gap to ensure the air gaps. This spacer 32 can be formed by, for example, stamping out from a heat-resistant resin sheet. However, it is not essential to provide the spacer 32. For example, the air gap 31 can otherwise be formed by forming regions having large surface roughness or protrusions, on at least one of the back surface of the ceramic base 11 and the surface of the temperature adjusting member 21which faces the ceramic base 11.

A gas introduction hole 25 is formed in the thickness direction thereof, so that a gas can be introduced to the air gap 31 from outside in a manner that its pressure can be controlled. The gas introduction hole 25 is a gas introduction path penetrating the temperature adjusting member 21, and communicates with the air gap 31. An o-ring 33 serving as a sealing member is fixed at the end portion of the air gap to prevent the gas introduced to the air gap 31 from leaking. The air gap 31 is tightly sealed by the o-ring 33.

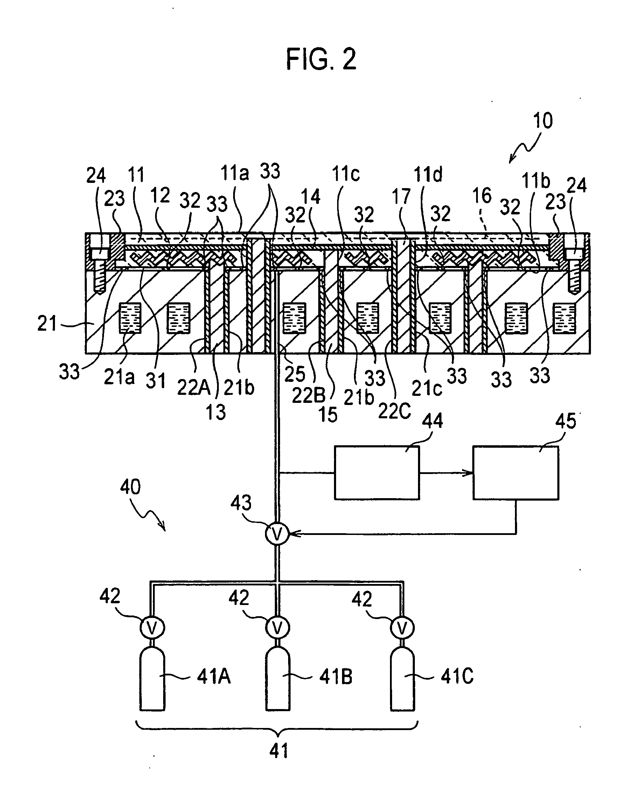

A gas introduction apparatus is connected to the gas introduction hole 25. By using Fig. 2, an example of the gas introduction apparatus will be described. A gas introduction apparatus 40 of the present embodiment shown in Fig. 2 includes a gas supply source 41, and conducts the gas accommodated in the gas supply source to the air gap 31. In the example shown in Fig. 2, the gas supply source 41 includes a first gas supply source 41A, a second gas supply source 41B and a third gas supply source 41C which accommodate different types of gases. A switching valve 42 is attached to each of the first gas supply source 41A, the second gas supply source 41B and the third gas supply source 41C, so that the gas supplied from the gas supply source 41 can be selected or mixed. A pressure control valve 43 and a pressure sensor 44 are provided on the way of a tubular path directed from the switching valve 42 to the gas introduction hole 25. Furthermore, a pressure controller 45 to which a signal from the pressure sensor 44 is inputted and which outputs a pressure control signal to the pressure control valve 43 is provided. The gas introduction apparatus 40 shown in Fig. 2 is merely an example, and as long as the system can introduce a gas to the air gap 31 in a manner that its pressure can be controlled, the system is not limited to this configuration.

The heating apparatus of the present embodiment has the tightly sealed air gap 31 between the ceramic base 11 and the temperature adjusting member 21. The gas introduction apparatus 40 is connected to the air gap 31 through the gas introduction hole 25. The gas can be introduced from the gas supply source 41 of the gas introduction apparatus 40 in a manner that its pressure can be controlled. The pressure of the gas introduced to the air gap 31 can be controlled by the pressure control valve 43, the pressure sensor 44 and the pressure controller 45.

A thermal conductivity of the gas such as helium varies depending on the applied pressure. More specifically, higher pressure increases the thermal conductivity. Accordingly, the amount of heat transferred from the ceramic base 11 to the temperature adjusting member 21 can be controlled by introducing a gas into the air gap 31 between the ceramic base 11 and the temperature adjusting member 21, and controlling the pressure of the gas. Consequently, the heating apparatus 10 of the present embodiment can control the temperature of the wafer over a wider temperature range, while maintaining an excellent thermal uniformity

The effect achieved by introducing the gas and controlling its pressure in the above-described manner can be lead to an achievement of a higher level of the thermal uniformity compared to the conventional heating apparatus. More specifically, in a conventional heating apparatus in which the ceramic base 11 and the temperature adjusting member 21 are adhesively fixed to each other with an adhesive, the amount of the heat transferred from the ceramic base 11 to the temperature adjusting member 21 differs significantly between when a wafer is heated at a relatively low temperature and when a wafer is heated at a high temperature, since the thermal conductivity of an adhesive is inherent to the adhesive. As a result, the electric power supplied to the resistance heating body embedded in the ceramic base 11 needs to be increased when heating a wafer at a high temperature. The larger the electric power supplied to the resistance heating body becomes, the more the thermal uniformity is deteriorated. Hence, the thermal uniformity is lowered when a wafer is heated at the high temperature. The present embodiment makes it possible to suppress such deterioration in the thermal uniformity by embedding the heat conductive member 14 in the ceramic base 11. However, when a difference in temperature between heating a wafer at a low temperature and heating the wafer at a high temperature is large, further improvement is required in the thermal uniformity when heating the wafer at a high temperature.

In this regard, in the heating apparatus 10 of the present embodiment, the gas introduction apparatus 40 can control the gas pressure in the air gap 31 between the ceramic base 11 and the temperature adjusting member 21. This makes it possible to control the gas pressure in the air gap 31 so that the pressure when the wafer is heated at a high temperature is lower than the pressure when the wafer is heated at a low temperature. When a gas pressure is low, the thermal conductivity of the gas is reduced. Consequently, the amount of the heat transferred from the ceramic base 11 to the temperature adjusting member 21 is also reduced. Thus, it is possible to heat a wafer at a high temperature without increasing the amount of the electric power supplied to the resistance heating body embedded in the ceramic base 11. As a result, an excellent thermal uniformity can be maintained while avoiding the deterioration.

In the present embodiment, the effect of the thermal uniformity achieved by enabling the control of the pressure in the air gap 31 between ceramic base 11 and the temperature adjusting member 21 is greater compared to the heating apparatus simply provided with the heat conductive member 14. That is to say, an excellent thermal uniformity beyond expectation can be achieved by a synergistic effect of enabling the control of the pressure in the air gap 31, and the effect of including the heat conductive member 14.

In the present embodiment, the gas pressure in the air gap 31 can be controlled by the pressure controller 45 connected to the pressure control valve 43 and the pressure sensor 44. Such control of the gas pressure in the air gap 31 can be easily carried out and is highly responsive. Therefore, it is excellent for an industrial application. In addition to the control of the gas pressure in the air gap 31 shown in the present embodiment, the amount of the heat transferred from the ceramic base 11 to the temperature adjusting member 21 can also be controlled by changing the distance of the air gap 31 or by changing the temperature of the cooling medium flowing through the fluid flow hole 21a of the temperature adjusting member 21. However, it is difficult to change the distance of the air gap 31 during heating of a wafer, and a system for changing the distance requires a system large in scale. Also, it is difficult to change the temperature of the cooling medium, particularly to heat or cool the cooling medium in a short time period, since the cooling medium is generally a liquid, having specific heat dramatically larger than a gas. It is similarly difficult to prepare a plurality of cooling media each having different temperatures and connecting to the fluid flow hole 21a of the temperature adjusting member 21. A large-scale system is required if the plurality of cooling media are to be used by switching the cooling media each having different temperatures depending on the heating temperature of a wafer. On the contrary, according to the heating apparatus 10 of the present embodiment, by controlling the gas pressure in the air gap 31, the amount of the heat transferred from the ceramic base 11 to the temperature adjusting member 21 can be changed in an extremely short time period. Thus, the throughput can be improved. In this heating apparatus 10 of the present embodiment, since only the addition of the simple gas introduction apparatus 40 is required, additional cost required for the equipment is small.

In the heating apparatus 10 of the present embodiment, the distance in the thickness direction of the air gap between the ceramic base 11 and the temperature adjusting member 21 is not particularly limited. The distance may be set to an appropriate value within an industrially applicable distance range. considering the heating temperature of a wafer, the gas pressure and the like.

Similarly, the gas pressure is not limited to a certain value, and may be set to an appropriate value within an industrially applicable pressure range, considering a wafer heating temperature, a gas pressure, the distance of the air gap 31 and the like.

A gas introduced to the air gap 31 may be the helium gas, for example. The helium gas is suitable as a gas used in the heating apparatus 10 of the present embodiment because of its large variation in the thermal conductivity depending on the change in pressures. However, the type of the gas to be used is not limited to the helium gas.

In the heating apparatus 10 of the present embodiment, the type of the gas to be introduced to the air gap 31 may be changed instead of controlling the gas pressure, or in addition to controlling the gas pressure. The thermal conductivity of the gas varies depending on the type of the gas. Accordingly, the same effect as that of controlling the gas pressure can be achieved by changing the type of the gas to be introduced to the air gap 31 by means of the switching valve 42 of the gas introduction apparatus 40. A usable gas includes helium gas, argon gas and nitrogen gas, for example.

### [Example]

### 1. Evaluation of the heat conductive member 14

Firstly, the thermal uniformity was evaluated using various types of the heat conductive member 14.

A ceramic sintered body serving as the upper portion of the ceramic base 11, a ceramic sintered body serving as the lower portion of the ceramic base 11, and the heat conductive member 14 were prepared.

A ceramic sintered body serving as the upper portion of the ceramic base 11 with an embedded electrostatic electrode was obtained in the following manner. A compact was formed from a raw material powder by means of press molding at the predetermined pressure using a mold, and then the compact was sintered by use of a hot press sintering method. A ceramic sintered body serving as the lower portion of the ceramic base 11 with an embedded resistance heating body was also obtained in the following manner. A compact was formed from a raw material powder by means of press molding at the predetermined pressure using a mold, and then the compact was sintered by use of a hot press sintering method.

Then, a thermal compression bonding was accomplished by sandwiching the heat conductive member 14 between the ceramic sintered body serving as the upper portion and the ceramic sintered body serving as the lower portion. The members were heated for the predetermined time period at the predetermined temperature, while being compressed at the predetermined pressure in their thickness direction. Thus, the ceramic base 11 shown in Fig. 1 in which the upper portion of the ceramic base 11, a thermal-compression- bonded layer composed of the heat conductive member 14, and the lower portion of the ceramic base 11 were laminated in the three-layer structure, was obtained. In this regard, the predetermined pressure, the predetermined temperature and the predetermined time period were defined in the following combination, depending on the material of the heat conductive member 14.

When the heat conductive member 14 was composed of aluminum, the pressure, the temperature and the time period were 70kgf/cm², 540°C, and 5hrs, respectively. When the heat conductive member 14 was composed of indium, the pressure, the temperature and the time period were 10kgf/cm², 130°C, and 5hrs, respectively.

After carrying out the thermal compression bonding, the heating surface of the ceramic base was surface-ground with a diamond grind stone. The side surface of a burned substance was ground, and at the same time necessary punching and mounting of a terminal were carried out to complete the ceramic base.

The obtained ceramic base was fixedly fastened to the temperature adjusting member 21 composed of a bulk aluminum by means of the bolt 24 via the ring-shaped fixture 23. Thus, the heating apparatus of the present embodiment shown in Fig. 1 was obtained.

For the purpose of comparison, a heating apparatus having the same structure as that of the present embodiment was manufactured, with the exception that it does not include the heat conductive member.

The heating surface of each heating apparatus thus obtained was heated to 100°C to examine the temperature distribution on the heating surface. The temperature distribution was measured by using an infrared spectroscope.

Tables 1 and 2 show the results of the examination of an inplane temperature variation (thermal uniformity) of the heating apparatus of the Examples 1 to 13 and Comparative examples 1 and 2.

**[Table 1]**

| | | Example | | | | | | | |
|---|---|---|---|---|---|---|---|---|---|
| | | 1 | 2 | 3 | 4 | 5 | 6 | 7 | 8 |
| Heat transfer member | Material | Al | In | Al | Al | Al | Al | Al | Al |
| | Thickness [mm] | 1 | 1 | 1 | 1 | 0.5 | 2 | 2.5 | 4 |
| | Thermal conductivity [W/m·K] | 237 | 82 | 237 | 237 | 237 | 237 | 237 | 237 |
| Upper ceramic base | Material | Al₂O₃ | Al₂O₃ | AIN | Y₂O₃ | Al₂O₃ | Al₂O₃ | Al₂O₃ | Al₂O₃ |
| | Thickness [mm] | 2 | 2 | 2 | 2 | 2 | 2 | 2 | 2 |
| | Thermal conductivity [W/m·K] | 30 | 30 | 100 | 15 | 30 | 30 | 30 | 30 |
| | Thermal expansion rate [ppm/K] | 7.8 | 7.8 | 5.0 | 8.0 | 7.8 | 7.8 | 7.8 | 7.8 |
| | Volume resistivity [Ω·cm] | 1.0×10¹⁶ | 1.0×10¹⁶ | 1.0×10¹⁰ | 1.0×10¹⁰ | 1.0×10¹⁶ | 1.0×10¹⁶ | 1.0×10¹⁶ | 1.0×10¹⁸ |
| | Embedded electrode | ESC | ESC | ESC | ESC | ESC | ESC | ESC | ESC |
| Lower ceramic base | Material | Al₂O₃ | Al₂O₃ | AIN | Y₂O₃ | Al₂O₃ | Al₂O₃ | Al₂O₃ | Al₂O₃ |
| | Thickness [mm] | 4 | 4 | 4 | 4 | 4 | 4 | 4 | 4 |
| | Thermal conductivity [W/m-K] | 30 | 30 | 100 | 15 | 30 | 30 | 30 | 30 |
| | Thermal expansion rate [ppm/K] | 7.8 | 7.8 | 5.0 | 8.0 | 7.8 | 7.8 | 7.8 | 7.8 |
| | Volume resistivity [Ω·cm] | 1.0×10¹⁶ | 1.0×10¹⁶ | 1.0×10¹⁰ | 1.0×10¹⁶ | 1.0×10¹⁶ | 1.0×10¹⁶ | 1.0×10¹⁶ | 1.0×10¹⁶ |
| | Embedded electrode | Heating apparatus | Heating apparatus | Heating apparatus | Heating apparatus | Heating apparatus | Heating apparatus | Heating apparatus | Heating apparatus |
| Thermal uniformity | [°C] | 1.8 | 3.9 | 0.9 | 2.8 | 3.7 | 1.4 | 1.2 | 1.0 |
| Temperature increasing rate@7000W | [°C/sec] | 2.0 | 2.0 | 1.6 | 2.1 | 2.2 | 1.8 | 1.7 | 1.2 |

**[Table 2]**

| | | Example | | | | | Comparative Example | |
|---|---|---|---|---|---|---|---|---|
| | | 9 | 10 | 11 | 12 | 13 | 1 | 2 |
| Heat transfer member | Material | Al | Al | Al | Al | Al | None | None |
| | Thickness [mm] | 5 | 1 | 1 | 1 | 1 | - | - |
| | Thermal conductivity [W/m·K] | 237 | 237 | 237 | 237 | 237 | - | - |
| Upper ceramic base | Material | Al₂O₃ | Y₂O₃ | Al₂O₃ | AIN | AIN | Al₂O₃ | Y₂O₃ |
| | Thickness [mm] | 2 | 2 | 2 | 2 | 2 | 2 | 2 |
| | Thermal conductivity [W/m·K] | 30 | 30 | 30 | 100 | 100 | 30 | 15 |
| | Thermal expansion rate [ppm/K] | 7.8 | 7.8 | 7.8 | 5.0 | 5.0 | 7.4 | 8.0 |
| | Volume resistivity [Ω cm] | 1.0×10¹⁶ | 1.0×10¹⁶ | 1.0×10¹⁴ | 1.0×10⁷ | 1.0×10¹⁰ | 1.0×10¹⁶ | 1.0×10¹⁶ |
| | Embedded electrode | ESC | ESC | ESC | ESC | ESC | ESC, Heating apparatus | ESC, Heating apparatus |
| Lower ceramic base | Material | Al₂O₃ | Al₂O₃ | Al₂O₃ | AIN | AIN | - | - |
| | Thickness [mm] | 4 | 4 | 4 | 4 | 4 | - | - |
| | Thermal conductivity [W/m-K] | 30 | 30 | 30 | 100 | 100 | - | - |
| | Thermal expansion rate [ppm/K] | 7.8 | 8.0 | 7.8 | 5.0 | 5.0 | - | - |
| | Volume resistivity [Ω cm] | 1.0×10¹⁶ | 1.0×10¹⁶ | 10×10¹⁶ | 10×10¹⁰ | 6.0×10⁶ | - | - |
| | Embedded electrode | Heating apparatus | Heating apparatus | Heating apparatus | Heating apparatus | Heating apparatus | - | - |
| Thermal uniformity | [°C] | 0.9 | 2.0 | 1.9 | 1.1 | 2.0 | 6.6 | 12.6 |
| Temperature increasing rate@7000W | [°C/sec] | 0.9 | 2.0 | 2.0 | 1.7 | 2.5 | 2.0 | 2.2 |

It can be seen from Tables 1 and 2 that in Examples 1 to 13 in which the heating apparatus includes the heat conductive member, the variations of the inplane temperature were smaller than those in Comparative examples 1 and 2. It is therefore understood that the heating apparatus of the present embodiment has a dramatically improved thermal uniformity.

Furthermore, when a high frequency electric power is supplied from the terminal connected to the heat conductive member in the heating apparatus of the present embodiment, a plasma atmosphere could be generated proximal to the heating surface.

### 2. Evaluation of the air gap 31

Then, the thermal uniformity was evaluated with respect to the air gaps 31 placed under various conditions.

The ceramic base 11 in which the heat conductive member 14 shown in Fig. 1 was embedded was prepared. The ceramic base 11 is composed of aluminum nitride, and the heat conductive member 14 is composed of aluminum having a thickness of 1.5 mm. The ceramic base 11 thus has a three-layer structure formed by the thermal compression bonding.

The obtained ceramic base 11 was fixedly fastened to the temperature adjusting member 21 composed of a bulk aluminum by means of the bolt 24. For the purpose of comparison, an example in which the ceramic base 11 and the temperature adjusting member 21 were fixedly jointed with an adhesive was prepared.

The distance of the air gap 31 between the ceramic base 11 and the temperature adjusting member 21, and the pressure of the gas introduced to the air gap 31 were changed in various ways to examine the thermal uniformity of the heating surface 11a of the ceramic base 11. The results are shown in Tables 3 and 4.

**[Table 3]**

| | | Example | | | | | | | | |
|---|---|---|---|---|---|---|---|---|---|---|
| | | Example 21 | | | Example 22 | | | Example 23 | | |
| | | Condition 1 | Condition 2 | Condition 3 | Condition 1 | Condition 2 | Condition 3 | Condition 1 | Condition 2 | Condition 3 |
| Fixation between ceramic base and temperature adjusting member | Fixing method | Clamp | Clamp | Clamp | Clamp | Clamp | Clamp | Clamp | Clamp | Clamp |
| | Air gap [mm] | 0.13 | 0.13 | 0.13 | 0.25 | 0.25 | 0.25 | 0.5 | 0.5 | 0.5 |
| | Introduced gas | He | He | He | He | He | He | He | He | He |
| | Gas pressure [Torr] | 100 | 10 | 3 | 100 | 20 | 50 | 60 | 30 | 10 |
| | Adhesion layer thickness [mm] | - | - | - | - | - | - | - | - | - |
| | Adhesion layer thermal conductivity [W/m·k] | - | - | - | - | - | - | - | - | - |
| Temperature of ceramic base | [°C] | 60 | 100 | 150 | 60 | 100 | 150 | 60 | 100 | 160 |
| Temperature of temperature adjusting member | [°C] | 30 | 30 | 30 | 30 | 30 | 30 | 30 | 30 | 30 |
| Rate of heat flow from ceramic base to temperature adjusting member | [W] | 2000 | 2100 | 2000 | 1500 | 2000 | 2100 | 700 | 1300 | 2000 |
| Thermal uniformity | [°C] | 1.8 | 1.9 | 1.9 | 1.5 | 1.8 | 1.9 | 0.8 | 1.2 | 1.8 |

**[Table 4]**

| | | Example | | | | | | Comparative example | | | | | |
|---|---|---|---|---|---|---|---|---|---|---|---|---|---|
| | | Example 24 | | | Example 25 | | | Comparative example 21 | | | Comparative example 22 | | Comparative example 23 |
| | | Condit ion 1 | Condit ion 2 | Condit ion 3 | Condit ion 1 | Condit ion 2 | Condit ion 3 | Condit ion 1 | Condit ion 2 | Condit ion 3 | Condit ion 1 | Condit ion 2 | Condition 1 |
| Fixation between ceramic base and temperature adjusting member | Fixing method | Clamp | Clamp | Clamp | Clamp | Clamp | Clamp | Adhes ion | Adhes ion | Adhes ion | Adhes ion | Adhes ion | Adhesion |
| | Air gap [mm] | 0.7 | 0.7 | 0.7 | 0.13 | 0.13 | 0.13 | - | - | - | - | - | - |
| | Introduced gas | He | He | He | Ar | Ar | Ar | | - | - | - | - | - |
| | Gas pressure [Torr] | 50 | 30 | 20 | 300 | 300 | 300 | - | - | - | - | - | - |
| | Adhesion layer thickness [mm] | - | - | - | - | - | - | 0.24 | 0.24 | 0.24 | 0.24 | 0.24 | 0.12 |
| | Adhesion layer thermal conductivity [W/m·k] | - | - | | - | - | - | 0.17 | 0.17 | 0.17 | 0.17 | 0.17 | 0.5 |
| Temperature of ceramic base | [°C] | 60 | 100 | 150 | 60 | 100 | 150 | 60 | 100 | 150 | 150 | 60 | 150 |
| Temperature of temperature adjusting member | [°C] | 30 | 30 | 30 | 30 | 30 | 30 | 30 | 30 | 30 | 80 | -10 | 30 |
| Rate of heat flow from ceramic base to temperature adjusting member | [W] | 600 | 1300 | 2100 | 400 | 900 | 2000 | 1300 | 3100 | 5300 | 3200 | 3000 | 21000 |
| Thermal uniformity | [°C] | 0.7 | 1.1 | 1.8 | 0.5 | 0.9 | 1.7 | 1.3 | 2.8 | 5.1 | 3 | 2.9 | - |

In Tables 3 and 4, Examples 21, 22, 23 and 24 are an example in which the distance of the air gap 31 is 0.13 mm, 0.25 mm, 0.5 mm and 0.7 mm, respectively. In any of Examples 21 to 24, the temperature of the heating surface 11a could be changed to 60°C, 100°C and 150°C respectively, by changing the gas pressure and by minimally changing the heat flow rate from the ceramic base 11 to the temperature adjusting member 21, i.e. an electric power supplied to the resistance heating body embedded in the ceramic base 11. Further, the thermal uniformity was excellent at each temperature of the heating surface.

Example 25 is an example in which the introduced gas is Ar. As in Example 25, even when the introduced gas was Ar, the temperature of the heating surface 11a could be changed to 60°C, 100°C and 150°C respectively, by minimally changing the heat flow rate from the ceramic base 11 to the temperature adjusting member 21, i.e. an electric power supplied to the resistance heating body embedded in the ceramic base 11. The thermal uniformity was also excellent at each temperature of the heating surface.

On the contrary, Comparative Example 21 is an example in which the ceramic base 11 and the temperature adjusting member 21 are fixedly jointed with an adhesive. The thermal conductivity of an adhesive is inherent to the adhesive. Accordingly, the heat flow rate from the ceramic base 11 to the temperature adjusting member 21 needs to be changed significantly, i.e. an electric power supplied to the resistance heating body embedded in the ceramic base 11 in order to change the temperature of the heating surface 11a to 60°C, 100°C and 150°C. In particular, supply of an amount of the electric power as large as 5,300W was required to change the temperature of the heating surface 11a to 150°C, resulting in a deterioration of the thermal uniformity.

Comparative example 22 is an example in which the ceramic baste 11 and the temperature adjusting member 21 are fixedly jointed with an adhesive and in which the temperature of the cooling medium flowing through the fluid flow hole 21a of the temperature adjusting member 21 is changed. When the temperature of the cooling medium was 80°C and -10°C, the heat flow rate from the ceramic base 11 to the temperature adjusting member 21 did not need to be changed significantly, i.e. an electric power supplied to the resistance heating body embedded in the ceramic base 11 in order to change the temperature of the heating surface 11a to 60°C and 150°C. The resultant thermal uniformity was smaller than those in Examples 1 to 4. Also, changing the temperature of the cooling medium took much time and the responsiveness for temperature control on the heating surface was insufficient.

Example 23 is an example in which the thickness of the adhesion layer is reduced as compared to that in Comparative example 21. In the Comparative Example 23, even when the heat flow rate from the ceramic base 11 to the temperature adjusting member 21, i.e. an electric power supplied to the resistance heating body embedded in the ceramic base 11 was increased to an excessive amount of 21000W, the amount was not sufficient to change the temperature of the heating surface 11a to 150°C.

## Claims

1. A heating apparatus comprising:
a base (11) composed of a ceramic, and having a heating surface (11a) on which a substrate is set;
a heating body (12) embedded in the base;
a heat conductive member (14) provided between the heating surface (11a) of the base and the heating body (12), and having a thermal conductivity higher than a thermal conductivity of the base (11); and
a temperature adjusting member (21) having a surface proximal to a back surface (11b) of the base and having a fluid flow hole (21a) for passage of a cooling medium,
**characterised in that**:
a gap (31) is provided between the back surface (11b) of the base and said surface of the temperature adjusting member (21), and is connectable to a gas introduction apparatus (40) which introduces a gas to the gap (31) while adjusting a gas pressure in the gap.

2. The heating apparatus according to claim 1, wherein the base (11) is composed of a ceramic which contains alumina as a main component.

3. The heating apparatus according to claim 1, wherein the base (11) is composed of a ceramic which contains yttrium oxide as a main component.

4. The heating apparatus according to claim 1, wherein the base (11) is composed of a ceramic which contains aluminum nitride as a main component.

5. The heating apparatus according to claim 2, wherein the heat conductive member (14) is composed of one of aluminum and aluminum alloy.

6. The heating apparatus according to claim 2, wherein the heat conductive member is composed of one of indium and indium alloy.

7. The heating apparatus according to any one of claims 1 to 6, wherein a thickness of the heat conductive member is about 0.5 mm to 5.0 mm.

8. The heating apparatus according to any one of claims 1 to 7, wherein the heat conductive member (14) is formed by a thermal compression bonding.

9. The heating apparatus according to any one of claims 1 to 8, wherein the heat conductive member (14) serves as a high frequency electrode.

10. The heating apparatus according to any one of claims 1 to 9, wherein
the base (11) is divided into an upper portion on which the substrate is set, and a lower portion which faces the temperature adjusting member, and
the base (11) has a three-layer structure having the heat conductive member (14) provided between the upper portion and the lower portion.

11. The heating apparatus according to any one of claims I to 10, wherein
the base comprises an electrostatic electrode (16) provided in the upper portion of the base, and
the heating body is provided (12) in the lower portion of the base.

12. The heating apparatus according to any one of claims 1 to 11, wherein
a fixture (23, 24) is disposed proximal to a circumferential portion of the base (11) and fixedly fastens the base (11) to the temperature adjusting member (21), and
said gap (31) is provided tightly sealed between the base and the temperature adjusting member, and communicates with an outside through a gas introduction path.

13. The heating apparatus according to claim 12, wherein
a spacer (32) is provided between the base and the temperature adjusting member which are fixedly fastened to each other by the fixture.

14. The heating apparatus according to claim 12 or 13, wherein
the gas introduction apparatus (40) is connected to the gap between the base and the temperature adjusting member, and introduces the gas while adjusting the gas pressure.

15. The heating apparatus according to claim 14, wherein
the gas introduction apparatus is arranged for selection of a type of the gas introduced to the air gap (31) between the base and the temperature adjusting member.

## Patentansprüche

1. Heizvorrichtung, die Folgendes umfasst:
eine Basis (11), die aus einem Keramikmaterial besteht und eine Heizfläche (11a) aufweist, auf die ein Substrat aufgebracht ist;
einen Heizkörper (12), der in die Basis eingebettet ist;
ein wärmeleitfähiges Element (14), das zwischen der Heizfläche (11a) der Basis und dem Heizkörper (12) bereitgestellt ist und eine höhere Wärmeleitfähigkeit als die Basis (11) aufweist; und
ein Temperatureinstellelement (21) mit einer Oberfläche in der Nähe einer hinteren Oberfläche (11b)der Basis und einem Fluiddurchflussloch (21 a), damit ein Kühlmedium hindurchtreten kann,
**dadurch gekennzeichnet, dass**:
ein Spalt (31) zwischen der hinteren Oberfläche (11b) der Basis und der Oberfläche des Temperatureinstellelements (21) bereitgestellt ist und mit einer Gaszuführvorrichtung (40) verbindbar ist, die Gas in den Spalt (31) einbringt, wobei der Gasdruck in dem Spalt eingestellt wird.

2. Heizvorrichtung nach Anspruch 1, worin die Basis (11) aus einem Keramikmaterial besteht, das Aluminiumoxid als Hauptkomponente enthält.

3. Heizvorrichtung nach Anspruch 1, worin die Basis (11) aus einem Keramikmaterial besteht, das Yttriumoxid als Hauptkomponente enthält.

4. Heizvorrichtung nach Anspruch 1, worin die Basis (11) aus einem Keramikmaterial besteht, das Aluminiumnitrid als Hauptkomponente enthält.

5. Heizvorrichtung nach Anspruch 2, worin das wärmeleitfähige Element (14) aus Aluminium oder einer Aluminiumlegierung besteht.

6. Heizvorrichtung nach Anspruch 2, worin das wärmeleitfähige Element (14) aus Indium oder einer Indiumlegierung besteht.

7. Heizvorrichtung nach einem der Ansprüche 1 bis 6, worin die Dicke des wärmeleitfähigen Elements etwa 0,5 mm bis 5,0 mm beträgt.

8. Heizvorrichtung nach einem der Ansprüche 1 bis 7, worin das wärmeleitfähige Element (14) durch Thermokompressionsbonden ausgebildet wird.

9. Heizvorrichtung nach einem der Ansprüche 1 bis 8, worin das wärmeleitfähige Element (14) als Hochfrequenzelektrode dient.

10. Heizvorrichtung nach einem der Ansprüche 1 bis 9, worin
die Basis (11) in einen oberen Abschnitt, auf dem das Substrat vorliegt, und einen unteren Abschnitt, der dem Temperatureinstellelement zugewandt ist, unterteilt ist und
die Basis (11) eine dreilagige Struktur aufweist, wobei das wärmeleitfähige Element (14) zwischen dem oberen Abschnitt und dem unteren Abschnitt bereitgestellt ist.

11. Heizvorrichtung nach einem der Ansprüche 1 bis 10, worin
die Basis eine elektrostatische Elektrode (16) umfasst, die in dem oberen Abschnitt der Basis bereitgestellt ist, und
der Heizkörper (12) in dem unteren Abschnitt der Basis bereitgestellt ist.

12. Heizvorrichtung nach einem der Ansprüche 1 bis 11, worin
eine Befestigung (23, 24) in der Nähe eines Umfangsabschnitts der Basis (11) angeordnet ist und die Basis (11) starr an dem Temperatureinstellelement (21) festlegt, und
der Spalt (31) dicht verschlossen zwischen der Basis und dem Temperatureinstellelement (21) bereitgestellt ist und mit der Außenumgebung über einen Gaseinbringpfad kommuniziert.

13. Heizvorrichtung nach Anspruch 12, worin
ein Beabstandungselement (32) zwischen der Basis und dem Temperatureinstellelement, die durch die Befestigung starr aneinander festgelegt sind, bereitgestellt ist.

14. Heizvorrichtung nach Anspruch 12 oder 13, worin
die Gaszufuhrvorrichtung (40) mit dem Spalt zwischen der Basis und dem Temperatureinstellelement verbunden ist und Gas einbringt, wobei der Gasdruck eingestellt wird.

15. Heizvorrichtung nach Anspruch 14, worin
die Gaszufuhrvorrichtung angeordnet ist, um einen Gastyp, der in den Luftspalt (31) zwischen der Basis und dem Temperatureinstellelement eingebracht wird, auszuwählen.

## Revendications

1. Appareil de chauffage comprenant :
une base (11) composée d'une céramique, et ayant une surface chauffante (11a) sur laquelle un substrat est placé ;
un corps chauffant (12) noyé dans la base ;
un élément thermiquement conducteur (14) prévu entre la surface chauffante (11a) de la base et le corps chauffant (12), et ayant une conductivité thermique supérieure à une conductivité thermique de la base (11) ; et
un élément d'ajustement de température (21) ayant une surface proximale par rapport à une surface arrière (11b) de la base et ayant un trou d'écoulement de fluide (21a) pour le passage d'un milieu de refroidissement,
**caractérisé en ce que** :
un espace (31) est prévu entre la surface arrière (11b) de la base et ladite surface de l'élément d'ajustement de température (21), et peut être raccordé à un appareil d'introduction de gaz (40) qui introduit un gaz dans l'espace (31) tout en ajustant une pression de gaz dans l'espace.

2. Appareil de chauffage selon la revendication 1, dans lequel la base (11) est composée d'une céramique qui contient de l'alumine en tant que composant principal.

3. Appareil de chauffage selon la revendication 1, dans lequel la base (11) est composée d'une céramique qui contient de l'oxyde d'yttrium en tant que composant principal.

4. Appareil de chauffage selon la revendication 1, dans lequel la base (11) est composée d'une céramique qui contient du nitrure d'aluminium en tant que composant principal.

5. Appareil de chauffage selon la revendication 2, dans lequel l'élément thermiquement conducteur (14) est composé de l'un parmi l'aluminium et un alliage d'aluminium.

6. Appareil de chauffage selon la revendication 2, dans lequel l'élément thermiquement conducteur est composé de l'un parmi l'indium et un alliage d'indium.

7. Appareil de chauffage selon l'une quelconque des revendications 1 à 6, dans lequel une épaisseur de l'élément thermiquement conducteur est de l'ordre de 0,5 mm à 5,0 mm.

8. Appareil de chauffage selon l'une quelconque des revendications 1 à 7, dans lequel l'élément thermiquement conducteur (14) est formé par une liaison de compression thermique.

9. Appareil de chauffage selon l'une quelconque des revendications 1 à 8, dans lequel l'élément thermiquement conducteur (14) sert d'électrode à haute fréquence.

10. Appareil de chauffage selon l'une quelconque des revendications 1 à 9, dans lequel :
la base (11) est divisée en une partie supérieure sur laquelle le substrat est placé, et une partie inférieure qui fait face à l'élément d'ajustement de température, et
la base (11) a une structure à trois couches ayant l'élément thermiquement conducteur (14) prévu entre la partie supérieure et la partie inférieure.

11. Appareil de chauffage selon l'une quelconque des revendications 1 à 10, dans lequel :
la base comprend une électrode électrostatique (16) prévue dans la partie supérieure de la base, et
le corps chauffant est prévu (12) dans la partie inférieure de la base.

12. Appareil de chauffage selon l'une quelconque des revendications 1 à 11, dans lequel :
une fixation (23, 24) est disposée à proximité d'une partie circonférentielle de la base (11) et fixe de manière fixe la base (11) à l'élément d'ajustement de température (21), et
ledit espace (31) est prévu de manière étanche entre la base et l'élément d'ajustement de température, et communique avec un intérieur par une trajectoire d'introduction de gaz.

13. Appareil de chauffage selon la revendication 12, dans lequel un dispositif d'espacement (32) est prévu entre la base et l'élément d'ajustement de température qui sont fixés de manière fixe entre eux par la fixation.

14. Appareil de chauffage selon la revendication 12 ou 13, dans lequel l'appareil d'introduction de gaz (40) est raccordé à l'espace situé entre la base et l'élément d'ajustement de température, et introduit le gaz tout en ajustant la pression de gaz.

15. Appareil de chauffage selon la revendication 14, dans lequel l'appareil d'introduction de gaz est agencé pour la sélection d'un type de gaz introduit dans l'espace d'air (31) situé entre la base et l'élément d'ajustement de température.
